# EUROPEAN PATENT APPLICATION

(11) **EP 4 726 779 A1**
(43) Date of publication of application: **15.04.2026**
(21) Application number: 24874839.4
(22) Date of filing: 25.07.2024
(51) Int. Cl.: H01L 25/075, H10H 20/00, H10H 20/851, H10H 20/841, H10H 20/857, H01L 21/304, B23K 26/36

(54) **DISPLAY APPARATUS AND METHOD OF MANUFACTURING SAME**

(30) Priority: 05.10.2023 KR 20230132894
(71) Applicant: Samsung Electronics Co., Ltd., Suwon-si, Gyeonggi-do 16677 (KR)
(72) Inventor: LEE, Hyeondong, Suwon-si, Gyeonggi-do 16677 (KR); KANG, Kihyung, Suwon-si, Gyeonggi-do 16677 (KR); KOH, Sungjun, Suwon-si, Gyeonggi-do 16677 (KR)
(74) Representative: Appleyard Lees IP LLP
(86) International application number: PCT/KR2024/010795
(87) International publication number: WO 2025/075280

(57) **Abstract**

A method of manufacturing a display module of a plurality of display modules arranged in a display apparatus includes forming a light-emitting layer on a base substrate, positioning a mask pattern having an aperture on the light-emitting layer, forming a plurality of inorganic light-emitting devices by etching the light-emitting layer through the aperture, forming a reflective layer on the mask pattern and the plurality of inorganic light-emitting devices, and removing the mask pattern positioned on the plurality of inorganic light-emitting devices and removing the reflective layer formed on the mask pattern.

## Description

### [Technical Field]

The disclosure relates to a display apparatus including inorganic light-emitting devices, and a method of manufacturing the same.

### [Background Art]

A display apparatus is a type of output device that visually displays data information, such as, characters and figures, and images.

In general, as a display apparatus, a liquid crystal panel requiring a backlight or an organic light-emitting diode (OLED) panel configured with a film of an organic compound that itself emits light in response to current has been widely used. However, the liquid crystal panel has slow response time and high power consumption, and requires a backlight because the liquid crystal panel itself does not emit light. Accordingly, it is difficult to compactify the liquid crystal panel. Also, although the OLED panel requires no backlight and thus implements a thin thickness because the OLED panel itself emits light, the OLED panel is vulnerable to a burn-in phenomenon in which, in situations where the OLED panel displays the same screen for a long time, a certain area of the screen remains as it is after the screen changes to another screen due to short life cycles of sub pixels. For these reasons, as a new panel for replacing the light crystal panel and the OLED panel, a micro light-emitting diode (micro LED or µLED) panel in which inorganic light-emitting devices are mounted on a substrate and the inorganic light-emitting devices themselves are used as pixels is being studied.

The micro light-emitting diode panel (hereinafter, referred to as a micro LED panel), which is a flat display panel, is configured with a plurality of inorganic LEDs each having a size of 100 micrometers (µm) or less.

The micro LED panel does not cause the burn-in phenomenon of OLEDs as inorganic light-emitting devices that are self-emissive devices, in addition to having excellent brightness, resolution, consumption power, and durability.

The micro LED panel provides better contrast, response time, and energy efficiency than the LCD panel requiring the backlight. Micro LEDs that are inorganic light-emitting devices have higher brightness, higher light-emitting efficiency, and a longer lifespan than OLEDs although both the OLEDs and micro LEDs have high energy efficiency.

In addition, the micro LEDs may achieve a substrate-level display modulation by arranging LEDs on a circuit board in units of pixels, and provide various resolutions and screen sizes according to the customer's order.

### [Disclosure]

Provided is a display apparatus with improved optical properties and a method of manufacturing the same.

Technical objects that can be achieved by the disclosure are not limited to the above-mentioned objects, and other technical objects not mentioned will be clearly understood by one of ordinary skill in the art to which the disclosure belongs from the following description.

According to an aspect of the disclosure, a method of manufacturing a display module of a plurality of display modules arranged in a display apparatus may include: forming a light-emitting layer on a base substrate; positioning a mask pattern having an aperture on the light-emitting layer; forming a plurality of inorganic light-emitting devices by etching the light-emitting layer through the aperture; forming a reflective layer on the mask pattern and the plurality of inorganic light-emitting devices; and removing the mask pattern positioned on the plurality of inorganic light-emitting devices and removing the reflective layer formed on the mask pattern.

According to an embodiment of the disclosure, in a display apparatus including a display module array in which a plurality of display modules are arranged, each of the plurality of display modules may include: a substrate; an inorganic light-emitting device configured to be mounted on the substrate and including both side surfaces; a color layer positioned in front of the inorganic light-emitting device to allow light emitted from the inorganic light-emitting device to pass therethrough and including quantum dots to allow light passing through the color layer to be color converted; and a reflective film positioned on both side surfaces of the inorganic light-emitting device to reflect the light emitted from the inorganic light-emitting device.

According to an embodiment of the disclosure, a method of manufacturing a display module of a plurality of display modules arranged in a display apparatus may include: forming a light-emitting layer on a base substrate; positioning a photoresist having an aperture on the light-emitting layer; forming a plurality of inorganic light-emitting structures by etching the light-emitting layer through the aperture of the photoresist; forming a reflective layer on a surface of the photoresist that forms the aperture and a surface of each of the plurality of inorganic light-emitting structures; and removing the reflective layer formed on the photoresist by dry etching the photoresist positioned on an upper surface of each of the plurality of inorganic light-emitting structures.

### [Description of Drawings]

FIG. 1 is a perspective view of a display apparatus according to some embodiments of the disclosure;
FIG. 2 is an exploded perspective view showing main components of a display apparatus according to some embodiments of the disclosure;
FIG. 3 is a rear perspective view of a display module of a display apparatus according to some embodiments of the disclosure;
FIG. 4 is a perspective view showing some components of a display module in a display apparatus according to some embodiments of the disclosure;
FIG. 5 is an enlarged cross-sectional view showing some components of a display module in a display apparatus according to some embodiments of the disclosure;
FIG. 6 is an enlarged cross-sectional view showing some components of a display module in a display apparatus according to some embodiments of the disclosure;
FIG. 7 is an enlarged cross-sectional view showing some components of a display module in a display apparatus according to some embodiments of the disclosure;
FIG. 8 is a flowchart illustrating a process of manufacturing a display module in a display apparatus according to some embodiments of the disclosure;
FIG. 9 is a schematic view illustrating a process of manufacturing a color layer of a display module in a display apparatus according to some embodiments of the disclosure;
FIG. 10 is a schematic view illustrating a process of manufacturing a display module in a display apparatus according to some embodiments of the disclosure;
FIG. 11 is a schematic view illustrating a process of manufacturing a display module in a display apparatus according to some embodiments of the disclosure;
FIG. 12 is a schematic view illustrating a process of manufacturing a display module in a display apparatus according to some embodiments of the disclosure;
FIG. 13 is a schematic view illustrating a process of manufacturing a display module in a display apparatus according to some embodiments of the disclosure;
FIG. 14 is a schematic view illustrating a process of manufacturing a display module in a display apparatus according to some embodiments of the disclosure;
FIG. 15 is a schematic view illustrating a process of manufacturing a display module in a display apparatus according to some embodiments of the disclosure;
FIG. 16 is a schematic view illustrating a process of manufacturing a display module in a display apparatus according to some embodiments of the disclosure;
FIG. 17 is a schematic view illustrating a process of manufacturing a display module in a display apparatus according to some embodiments of the disclosure; and
FIG. 18 is a schematic view illustrating a process of manufacturing a display module in a display apparatus according to some embodiments of the disclosure.

### [Modes of the Disclosure]

Configurations illustrated in the drawings and the embodiments described in the disclosure are only examples, and thus it is to be understood that various modified examples, which may replace the embodiments and the drawings of the disclosure, are possible when filing the present application.

Like reference numerals may be used for like or related elements throughout the drawings.

The terms used herein are used only to describe particular embodiments and are not intended to limit the disclosure. The singular form of a noun corresponding to an item may include one or more items unless the context states otherwise. It will be understood that when the terms "includes," "comprises," "including," and/or "comprising," when used in this specification, specify the presence of stated features, figures, steps, operations, components, members, or combinations thereof, but do not preclude the presence or addition of one or more other features, figures, steps, operations, components, members, or combinations thereof.

In the disclosure, phrases, such as "A or B", "at least one of A and B", "at least one of A or B," "A, B or C," "at least one of A, B and C," and "at least one of A, B, or C", may include any one or all possible combinations of items listed together in the corresponding phrase among the phrases.

As used herein, the term "and/or" includes any and all combinations of one or more of a plurality of associated listed items.

It will be understood that, although the terms "first," "second," etc. may be used herein to describe various elements, the elements are not restricted by the terms, and the terms are only used to distinguish one element from another. For example, a first element could be termed a second element, and similarly, a second element could be termed a first element without departing from the scope of the disclosure. The term "and/or" includes combinations of one or all of a plurality of associated listed items.

In the disclosure, the meaning of "identical" may include similar in attribute or similar within a certain range. Also, the term "identical" means "substantially identical". The meaning of "substantially identical" should be understood that a value falling within the margin of error in manufacturing or a value corresponding to a difference within a meaningless range with respect to a reference value is included in the range of "identical".

In the following description, the terms "front", "rear", "left", and "right" are defined based on the drawings, and the shapes and positions of the components are not limited by the terms.

Hereinafter, embodiments of the disclosure are described in detail with reference to accompanying drawings.

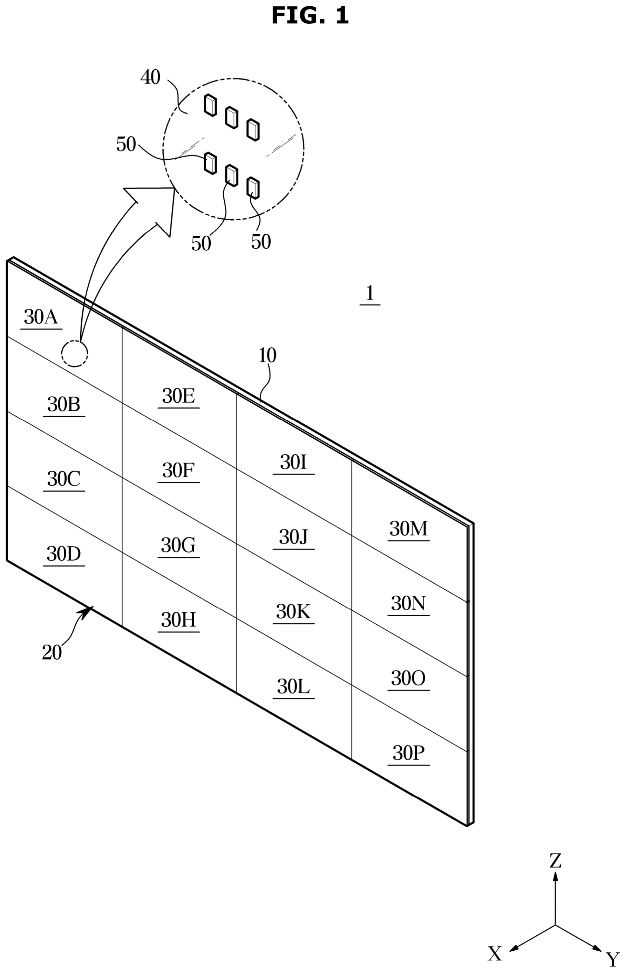

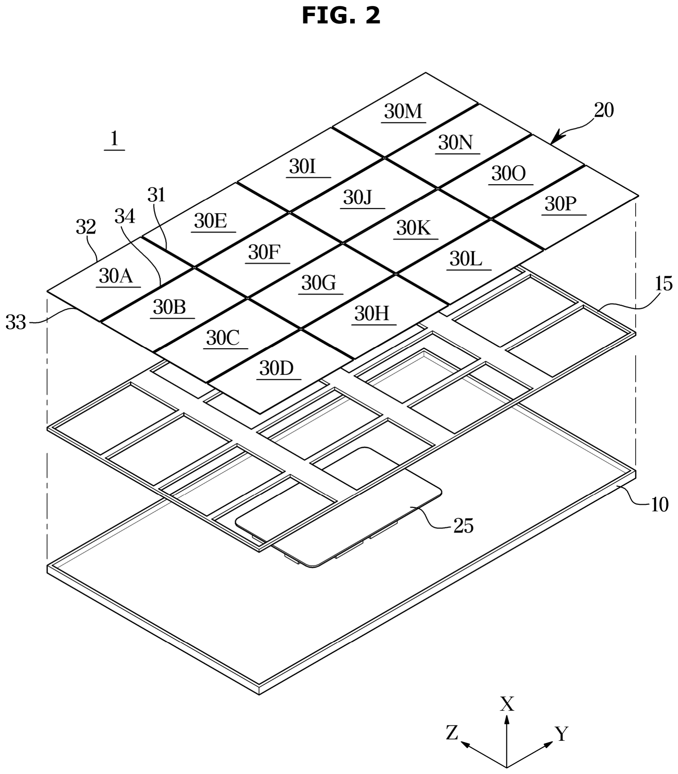

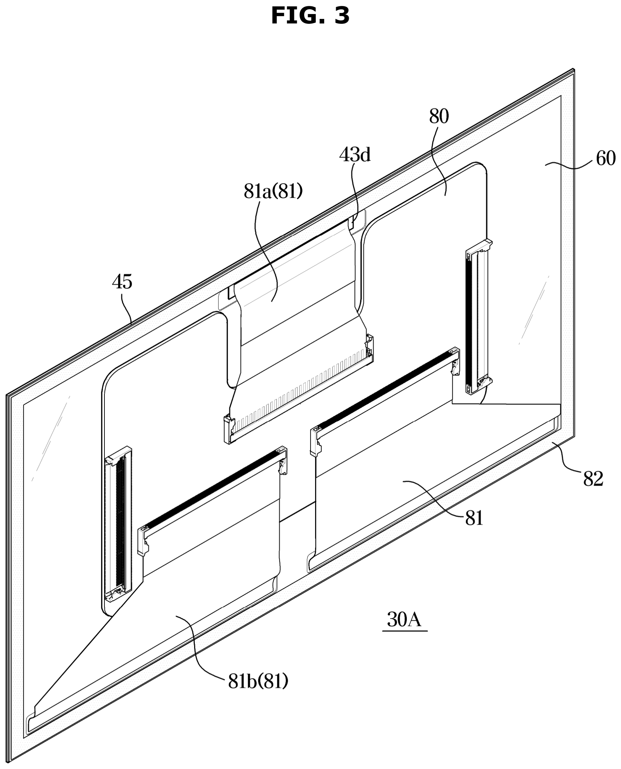

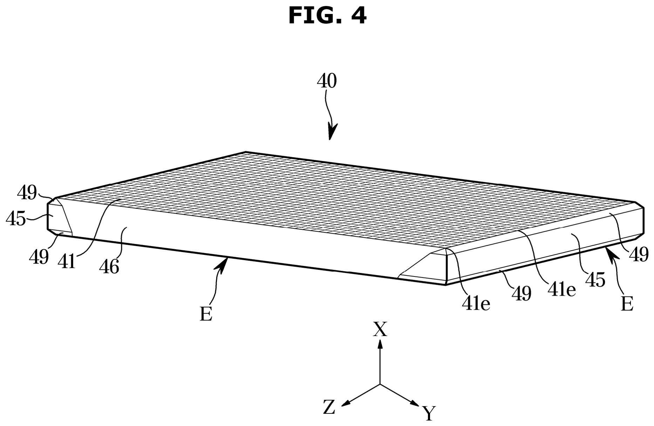

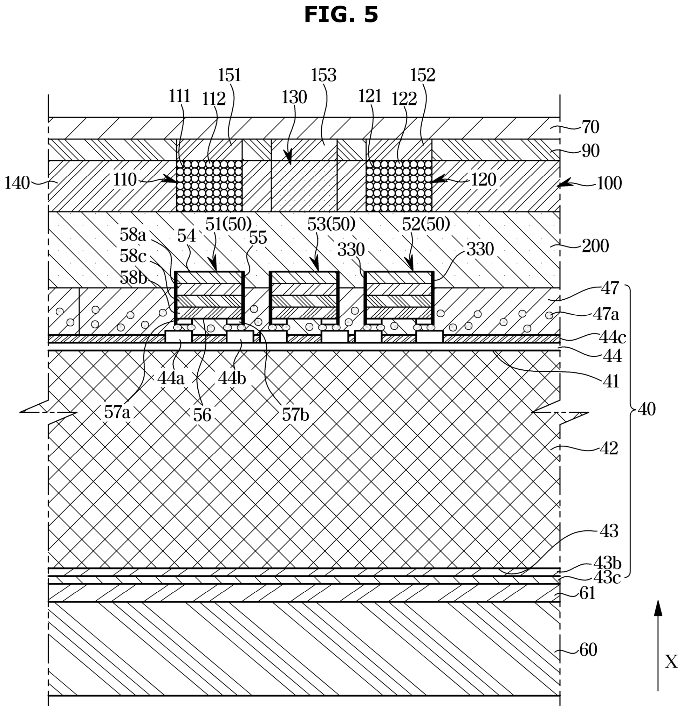

FIG. 1 is a perspective view of a display apparatus according to some embodiments of the disclosure. FIG. 2 is an exploded perspective view showing main components of a display apparatus according to some embodiments of the disclosure. FIG. 3 is a rear perspective view of a display module of a display apparatus according to some embodiments of the disclosure. FIG. 4 is a perspective view showing some components of a display module in a display apparatus according to some embodiments of the disclosure. FIG. 5 is an enlarged cross-sectional view showing some components of a display module in a display apparatus according to some embodiments of the disclosure.

Some components of a display apparatus 1, including a plurality of inorganic light-emitting devices 50 shown in the drawings may be micro-scale components having sizes of several micrometers (µm) to several hundreds of micrometers (µm), and some components (for example, the plurality of inorganic light-emitting devices 50, etc.) are shown with exaggerated sizes for convenience of description.

The display apparatus 1 may be an apparatus for displaying information and data as characters, figures, graphs, images, etc., and the display apparatus 1 may be a television (TV), a Personal Computer (PC), a mobile device, a digital signage, etc.

Referring to FIG. 1 and FIG. 2, according to some embodiments of the disclosure, the display apparatus 1 may include a display panel 20 for displaying images, a power supply for supplying power to the display panel 20, a main board 25 for controlling overall operations of the display panel 20, a frame 15 supporting the display panel 20, and a rear cover 10 covering a rear side of the frame 15.

The display panel 20 may include a plurality of display modules 30A to 30P, a driving board (not shown) for driving the display modules 30A to 30P, and a Timing Controller (TCON) board for generating timing signals required for controlling the respective display modules 30A to 30P.

The rear cover 10 may support the display panel 20. The rear cover 10 may be placed above a floor through a stand, or mounted on a wall through a hanger, etc.

The plurality of display modules 30A to 30P may be arranged in up, down, left, and right directions in such a way as to be adjacent to each other. The plurality of display modules 30A to 30P may be arranged in a matrix type of M*N. In the current embodiment, 16 display modules 30A to 30P may be provided and arranged in a matrix type of 4*4. However, a number and arrangement of the plurality of display modules 30A to 30P are not limited to these.

The plurality of display modules 30A to 30P may be mounted on the frame 15. The plurality of display modules 30A to 30P may be mounted on the frame 15 by various known methods, such as a magnetic force by a magnet, a mechanical fixing structure, etc. The rear cover 10 may be coupled to a rear side of the frame 15, and the rear cover 10 may form a rear outer appearance of the display apparatus 1.

The rear cover 10 may include a metal material. Accordingly, heat generated from the plurality of display modules 30A to 30P and the frame 15 may be efficiently conducted to the rear cover 10, resulting in improvement of heat dissipation performance of the display apparatus 1.

In this way, the display apparatus 1 according to some embodiments of the disclosure may implement a large screen by tiling the plurality of display modules 30A to 30P..

Each of the plurality of display modules 30A to 30P may be applied to a display apparatus. For example, each of the display modules 30A to 30P may be installed in various electronic products or electric devices, such as wearable devices, portable devices, and handheld devices, requiring displays, and as in the embodiment of the disclosure, the plurality of display modules 30A to 30P may be assembled and arranged in a matrix type to be applied to display apparatuses, such as PC monitors, high-resolution TVs, signage, and electronic displays.

The plurality of display modules 30A to 30P may have the same configuration. Accordingly, the following description about a display module may be applied in the same way to all the other display modules.

Hereinafter, because the plurality of display modules 30A to 30P have the same configuration, the plurality of display modules 30A to 30P will be described based on a first display module 30A.

For example, to avoid redundant descriptions, main components of each of the plurality of display modules 30A to 30P will be described to be a display module 30, a substrate 40, and a front cover 70.

Also, the first display module 30A among the plurality of display modules 30A to 30P and a second display module 30E positioned adjacent to the first display module 30A in a second direction Y or a third display module 30B positioned adjacent to the first display module 30A in a third direction Z will be described as necessary.

As an example, the first display module 30A among the plurality of display modules 30A to 30P may be a quadrangle type. However, the first display module 30A may be a rectangle type or a square type.

Accordingly, the first display module 30A may include edges 31, 32, 33, and 34 formed in upper, lower, left, and right directions with respect to a first direction X which is a front direction.

For example, a left-right direction of the display apparatus 1, which is orthogonal to the first direction X being toward the front direction of the display apparatus 1, is referred to as the second direction Y, and an up-down direction of the display apparatus 1, which is orthogonal to the first direction X and the second direction Y, is referred to as the third direction Z.

Referring to FIG. 3 and FIG. 4, a side wiring 46 may extend along the third direction Z toward a rear surface 43 of the substrate 40 via a chamfer portion 49 and a side surface 45 of the substrate 40 positioned in the third direction Z, although not limited thereto..

However, the side wiring 46 may extend along the second direction Y toward the rear surface 43 of the substrate 40 via the chamfer portion 49 and the side surface 45 of the substrate 40 positioned in the second direction Y.

According to some embodiments of the disclosure, the side wiring 46 may extend along edges E of the substrate 40, corresponding to an upper edge 32 and a lower edge 34 of the first display module 30A, although not limited thereto.

However, the side wiring 46 may extend along edges E of the substrate 40, corresponding to at least two edges among the four edges 31, 32, 33, and 34 of the first display module 30A.

An upper wiring layer may be connected to the side wiring 46 by an upper connection pad formed at the edges E of the substrate 40.

The side wiring 46 may extend along the side surface 45 of the substrate 40 and be connected to a rear wiring layer 43b formed on the rear surface 43.

An insulating layer 43c covering the rear wiring layer 43b may be formed on the rear wiring layer 43b in a direction in which the rear surface of the substrate 40 faces.

The display apparatus 1 may include the plurality of inorganic light-emitting devices 50. The plurality of inorganic light-emitting devices 50 may be electrically connected to the upper wiring layer, the side wiring 46, and the rear wiring layer 43b sequentially.

Also, the first display module 30A may include a driving circuit board 80 for electrically controlling the plurality of inorganic light-emitting devices 50 mounted on a mounting surface 41. The driving circuit board 80 may be a printed circuit board. The driving circuit board 80 may be positioned on the rear surface 43 of the substrate 40 in the first direction X. The driving circuit board 80 may be positioned on a metal plate 60 adhered on the rear surface 43 of the substrate 40.

The first display module 30A may include a flexible film 81 connecting the driving circuit board 80 to the rear wiring layer 43b to electrically connect the driving circuit board 80 to the plurality of inorganic light-emitting devices 50.

More specifically, one end of the flexible film 81 may be positioned on the rear surface 43 of the substrate 40 and connected to a rear connection pad 43d electrically connected to the plurality of inorganic light-emitting devices 50.

The rear connection pad 43d may be electrically connected to the rear wiring layer 43b. Accordingly, the rear connection pad 43d may electrically connect the rear wiring layer 43b to the flexible film 81.

Because the flexible film 81 is electrically connected to the rear connection pad 43d, the flexible film 81 may transfer power and electrical signals from the driving circuit board 80 to the plurality of inorganic light-emitting devices 50.

The flexible film 81 may be formed as a Flexible Flat Cable (FFC), a Chip On Film (COF), etc.

The flexible film 81 may include a first flexible film 81a and a second flexible film 81b positioned in upper and lower directions with respect to the first direction X that is the front direction.

However, the first flexible film 81a and the second flexible film 81b may be positioned in left and right directions with respect to the first direction X or in at least two directions of the upper, lower, left, and right directions.

A plurality of second flexible films 81b may be provided, although not limited thereto. However, a single second flexible film 81b may be provided and a plurality of first flexible films 81a may be provided.

The first flexible film 81a may transfer a data signal from the driving circuit board 80 to the substrate 40. The first flexible film 81a may be a COF.

The second flexible film 81b may transfer power from the driving circuit board 80 to the substrate 40. The second flexible film 81b may be a FFC.

However, the first flexible film 81a and the second flexible film 81b may be formed in reverse.

Although not illustrated, the driving circuit board 80 may be electrically connected to a main board 25 (see FIG. 2). The main board 25 may be positioned behind the frame 15, and the main board 25 may be connected to the driving circuit board 80 through a cable (not shown) behind the frame 15.

The metal plate 60 may be in contact with the substrate 40. The metal plate 60 may be adhered to the substrate 40 by a rear adhesive tape 61 positioned between the rear surface 43 of the substrate 40 and the metal plate 60 (see FIG. 5).

The metal plate 60 may be formed of a metal material having high heat conductivity. For example, the metal plate 60 may be formed of an aluminum material.

Heat generated from a Thin Film Transistor (TFT) layer 44 and the plurality of inorganic light-emitting devices 50 mounted on the substrate 40 may be transferred to the metal pate 60 through the rear adhesive tape 61 along the rear surface 43 of the substrate 40.

Accordingly, heat generated from the substrate 40 may be efficiently transferred to the metal plate 60, and temperature of the substrate 40 may be prevented from rising above a certain temperature.

The plurality of display modules 30A to 30P may be positioned respectively at various locations in a matrix type of M*N. The display modules 30A to 30P may be independently movable. In this case, each of the display modules 30A to 30P may include the metal plate 60 to maintain a certain level of heat dissipation performance regardless of a location of the display module.

The plurality of display modules 30A to 30P may be arranged in various matrix types of M*N to form various sizes of screens of the display apparatus 1. Accordingly, heat dissipation of each of the display modules 30A to 30P by including a plurality of metal plates 60 respectively in the display modules 30A to 30P, according to an embodiment of the disclosure may improve total heat dissipation performance of the display apparatus 1, compared to heat dissipation through a single metal plate provided for temporary heat dissipation.

In a case where a single metal plate is positioned inside the display apparatus 1, some portion of the metal plate may be not positioned at locations corresponding to locations where some display modules are positioned, and some portion of the metal plate may be positioned at a location where no display module is positioned, in a front-rear direction. In this case, heat dissipation efficiency of the display apparatus 1 may deteriorate.

Because the metal plate 60 is positioned at each of the display modules 30A to 30P, all the display modules 30A to 30P may themselves dissipate heat by the metal plate 60 regardless of locations of the display modules 30A to 30P, which improves the total heat dissipation performance of the display apparatus 1.

The metal plate 60 may be provided in a quadrangle type substantially corresponding to a shape of the substrate 40.

The substrate 40 may have an area that is at least equal to or larger than that of the metal plate 60. The substrate 40 and the metal plate 60 may be positioned side by side in the first direction X. In this case, four edges of the substrate 40 being a rectangle type may correspond to four edges of the metal plate 60 with respect to a center of the substrate 40 and the metal plate 60, or the four edges of the substrate 40 may be positioned outward from the four edges of the metal plate 60 with respect to the center of the substrate 40 and the metal plate 60.

The four edges E of the substrate 40 may be positioned outward from the four edges of the metal plate 60. For example, the area of the substrate 40 may be larger than that of the metal plate 60.

As a result of heat transfer to each of the display modules 30A to 30P, the substrate 40 and the metal plate 60 may be thermally expanded. However, because the metal plate 60 has a greater thermal expansion rate than the substrate 40, an expansion value of the metal plate 60 may be greater than that of the substrate 40.

In this case, in a case in which the four edges E of the substrate 40 correspond to the four edges of the metal plate 60 or are positioned inward from the four edges of the metal plate 60, the edges of the metal plate 60 may protrude outward from the substrate 40.

Accordingly, gaps between the display modules 30A to 30P may become irregular due to the thermal expansion of the metal plate 60 of each of the display modules 30A to 30P, and thus, visibility of some seams may rise, resulting in deterioration of a sense of unity of a screen of the display panel 20.

However, in the case in which the four edges E of the substrate 40 are positioned outward from the four edges of the metal plate 60, the metal plate 60 may not protrude outward from the four edges E of the substrate 40 although the substrate 40 and the metal plate 60 are thermally expanded, and accordingly, the display modules 30A to 30P may be maintained with constant gaps.

In addition, to maintain the display modules 30A to 30P at constant gaps, a front side of the frame 15 supporting the display modules 30A to 30P may have a similar material property to that of the substrate 40. For example, the display modules 30A to 30P may be adhered to the front side of the frame 15.

According to some embodiments of the disclosure, the area of the substrate 40 may substantially correspond to that of the metal plate 60. Accordingly, heat generated from the substrate 40 may be uniformly dissipated through the entire area of the substrate 40 without being isolated at some areas.

The metal plate 60 may be adhered to the rear surface 43 of the substrate 40 by the rear adhesive tape 61.

The rear adhesive tape 61 may be provided with a size corresponding to the metal plate 60. For example, an area of the rear adhesive tape 61 may correspond to that of the metal plate 60. The metal plate 60 may be substantially a quadrangle type, and the rear adhesive tape 61 may also be a quadrangle type correspondingly.

Edges of the rear adhesive tape 61 may correspond to the edges of the metal plate 60 being a rectangle type with respect to a center of the metal plate 60 and the rear adhesive tape 61.

Accordingly, the metal plate 60 and the rear adhesive tape 61 may be easily manufactured as a coupled component, which contributes to an increase of manufacturing efficiency of the display apparatus 1.

For example, by adhering the rear adhesive tape 61 to a metal plate and then cutting the metal plate and the rear adhesive tape 61 together into preset units, a number of processes may be reduced.

Heat generated from the substrate 40 may be transferred to the metal plate 60 through the rear adhesive tape 61. Accordingly, the rear adhesive tape 61 may adhere the metal plate 60 to the substrate 40 and transfer heat generated from the substrate 40 to the metal plate 60.

Accordingly, the rear adhesive tape 61 may include a material having high heat dissipation performance.

Basically, the rear adhesive tape 61 may include an adhesive material to adhere the substrate 40 to the metal plate 60.

In addition, the rear adhesive tape 61 may include a material having high heat dissipation performance, rather than a normal adhesive material. Accordingly, the rear adhesive tape 61 may efficiently transfer heat between the substrate 40 and the metal plate 60.

Also, the adhesive material of the rear adhesive tape 61 may be a material having higher heat dissipation performance than an adhesive material forming a normal adhesive.

The material having higher heat dissipation performance may be a material capable of effectively transferring heat due to high heat conductivity, high heat transfer performance, and low specific heat.

For example, the rear adhesive tape 61 may include a graphite material, although not limited thereto. However, the rear adhesive tape 61 may be a normal material having high heat dissipation performance.

The rear adhesive tape 61 may have higher flexibility than those of the substrate 40 and the metal plate 60. Accordingly, the rear adhesive tape 61 may be formed of a material having adhesiveness, heat dissipation performance, and high flexibility. The rear adhesive tape 61 may be a baseless double-sided tape. As described above, because the rear adhesive tape 61 is a baseless tape, the rear adhesive tape 61 may be a single layer without any base positioned between one side adhered to the substrate 40 and another side adhered to the metal plate 60 to support the both sides.

Because the rear adhesive tape 61 includes no base, the rear adhesive tape 61 may not include any material that may interrupt heat transfer, and accordingly, heat dissipation performance may be improved. However, the rear adhesive tape 61 is not limited to a baseless double-sided tape, and may be a heat dissipation tape having higher heat dissipation performance than a normal double-sided tape.

To absorb any external force transferred from the substrate 40 and the metal plate 60, the rear adhesive tape 61 may be formed of a material having high flexibility. More specifically, the flexibility of the rear adhesive tape 61 may be higher than those of the substrate 40 and the metal plate 60.

Accordingly, although heat is transferred to the substrate 40 and the metal plate 60 and thus, an external force generated by changes in size of the substrate 40 and the metal plate 60 is transferred to the rear adhesive tape 61, the rear adhesive tape 61 may itself be deformed to prevent the external force from being transferred to other components.

The rear adhesive tape 61 may have a preset thickness in the first direction X. Upon thermal expansion of the metal plate 60 due to heat transferred to the metal plate 60 or contraction of the metal plate 60 cooled, the metal plate 60 may be expanded or contracted in the first direction X and directions that are orthogonal to the first direction X, and accordingly, an external force may be transferred to the substrate 40.

Because the metal plate 60 is formed with a size corresponding to the substrate 40 and covers the entire rear surface 43 of the substrate 40, as described above, a fixing member 82 may be positioned on a rear surface of the metal plate 60, although not limited thereto.

However, the fixing member 82 may be positioned on the rear surface 43 of the substrate 40. In this case, the substrate 40 may be adhered directly to the frame 15 through the fixing member 82.

The metal plate 60 may cover only an area of the rear surface 43 of the substrate 40, and the fixing member 82 may be adhered to another area of the rear surface 43 of the substrate 40, not covered by the metal plate 60.

The fixing member 82 may be, for example, a double-sided tape.

Referring to FIG. 5, each of the plurality of display modules 30A to 30P may include the substrate 40 and the plurality of inorganic light-emitting devices 50 mounted on the substrate 40. The substrate 40 may be a light source substrate 40. The plurality of inorganic light-emitting devices 50 may be mounted on the mounting surface 41 of the substrate 40 toward the first direction X. The mounting surface 41 may be a first surface. Also, the mounting surface 41 may be positioned on a first side of the substrate 40, and the metal plate 60 may be positioned on a second side of the substrate 40, the second side being opposite to the first side. For convenience of description, in FIG. 5, a thickness of the substrate 40 in the first direction X is shown to be exaggeratedly great. The first direction X may be the front direction.

The substrate 40 may be a quadrangle type. Each of the plurality of display modules 30A to 30P may be a quadrangle type, as described above, and the substrate 40 may also be a quadrangle type correspondingly.

The substrate 40 may be a rectangle type or a square type.

Accordingly, for example, in the first display module 30A, the substrate 40 may include the four edges E corresponding to the edges 31, 32, 33, and 34 of the first display module 30A, formed in the upper, lower, left, and right directions with respect to the first direction X that is the front direction (see FIG. 4).

The substrate 40 may include a substrate body 42, the mounting surface 41 forming one side of the substrate body 42, the rear surface 43 forming another side of the substrate body 42 and being opposite to the mounting surface 41, and the side surface 45 positioned between the mounting surface 41 and the rear surface 43.

The side surface 45 may form a side end of the substrate 40 in the second direction Y and the third direction Z that are orthogonal to the first direction X.

The substrate 40 may include the chamfer portion 49 formed between the mounting surface 41 and the side surface 45 and between the rear surface 43 and the side surface 45.

The chamfer portion 49 may prevent substrates from colliding with each other and being broken upon arrangement of the plurality of display modules 30A to 30P.

The edges E of the substrate 40 may include the side surface 45 and the chamfer portion 49.

The substrate 40 may include the TFT layer 44 formed on the substrate body 42 to drive the inorganic light-emitting devices 50. The substrate body 42 may include a glass substrate. For example, the substrate 40 may include a Chip On Glass (COG) type substrate 40. On the substrate 40, a first pad electrode 44a and a second pad electrode 44b for electrically connecting the inorganic light-emitting devices 50 to the TFT layer 44 may be formed.

TFTs constituting the TFT layer 44 are not limited to specific structures or types and may be configured as one or more embodiments. For example, TFTs of the TFT layer 44 according to some embodiments of the disclosure may be implemented as Low Temperature Poly Silicon (LTPS) TFTs, oxide TFTs, Si (poly silicon or a-silicon) TFTs, organic TFTs, graphene TFTs, etc.

Also, according to the substrate body 42 of the substrate 40, provided as a silicon wafer, the TFT layer 44 may be replaced with a Complementary Metal-Oxide Semiconductor (CMOS) type, a n-type Metal-Oxide Semiconductor Field Effect Transistor (MOSFET), or a p-type MOSFET.

The plurality of inorganic light-emitting devices 50 may be formed of an inorganic material, and may include inorganic light-emitting devices having sizes of several micrometers (µm) to tens of micrometers (µm) in width, length, and height, respectively. A micro inorganic light-emitting device may have a shorter side length of 100 micrometers (µm) or less in width, length, and height. For example, the inorganic light-emitting devices 50 may be picked up from a sapphire or silicon wafer and then transferred directly onto the substrate 40. The plurality of inorganic light-emitting devices 50 may be picked up and conveyed through an electrostatic method using an electrostatic head or a stamp method using an elastic polymer material, such as polydimethylsiloxane (PDMS) or silicon, as a head.

The plurality of inorganic light-emitting devices 50 may be a light-emitting structure including an n-type semiconductor 58a, an active layer 58c, and a p-type semiconductor 58b.

The display module 30 may further include a first contact electrode 57a and a second contact electrode 57b. However, the first contact electrode 57a and the second contact electrode 57b may be included in the plurality of inorganic light-emitting devices 50.

Although not illustrated, any one of the first contact electrode 57a and the second contact electrode 57b may be electrically connected to the n-type semiconductor 58a, and another one may be electrically connected to the p-type semiconductor 58b.

The first contact electrode 57a and the second contact electrode 57b may be a flip chip type arranged horizontally toward the same direction (an opposite direction of a light-emitting direction).

Each inorganic light-emitting device 50 may include a light-emitting surface 54 positioned toward the first direction X upon being mounted on the mounting surface 41, a side surface 55, and a bottom surface 56 being opposite to the light-emitting surface 54, wherein the first contact electrode 57a and the second contact electrode 57b may be formed on the bottom surface 56.

For example, the first and second contact electrodes 57a and 57b of the inorganic light-emitting device 50 may be opposite to the light-emitting surface 54, and accordingly, the first and second contact electrodes 57a and 57b may be positioned in the opposite direction of the light-emitting direction.

The first and second contact electrodes 57a and 57b may face the mounting surface 41, and be electrically connected to the TFT layer 44. Also, the light-emitting surface 54 through which light is radiated may be positioned in an opposite direction of the direction in which the first and second contact electrodes 57a and 57b are positioned.

Accordingly, light generated by the active layer 58c may be radiated toward the first direction X through the light-emitting surface 54, without any interference by the first and second contact electrodes 57a and 57b.

For example, the first direction X may be defined as a direction in which the light-emitting surface 54 is positioned to radiate light.

The first contact electrode 57a and the second contact electrode 57b may be electrically connected respectively to the first pad electrode 44a and the second pad electrode 44b formed on the mounting surface 41 of the substrate 40.

The inorganic light-emitting device 50 may be connected directly to the first and second pad electrodes 44a and 44b through an anisotropic conductive layer 47 or a bonding material such as a solder.

On the substrate 40, the anisotropic conductive layer 47 may be formed to mediate an electrical connection between the first and second contact electrodes 57a and 57b and the first and second pad electrodes 44a and 44b. The anisotropic conductive layer 47 may be formed by applying an anisotropic conductive adhesive on a protective film, and have a structure in which conductive balls 47a are distributed in an adhesive resin. Each conductive ball 47a may be a conductive sphere surrounded by a thin insulating film, and as a result of breaking of the insulating film by pressure, the conductive ball 47a may electrically connect a conductor to another one.

The anisotropic conductive layer 47 may include an Anisotropic Conductive Film (ACF) being in a form of a film, and an Anisotropic Conductive Paste (ACP) being in a form of a paste.

In some embodiments of the disclosure, the anisotropic conductive layer 47 may be provided as an anisotropic conductive film.

Accordingly, the insulating films of the conductive balls 47a may be broken by pressure applied to the anisotropic conductive layer 47 upon mounting of the plurality of inorganic light-emitting devices 50 on the substrate 40, and as a result, the first and second contact electrodes 57a and 57b of the inorganic light-emitting devices 50 may be electrically connected to the first and second pad electrodes 44a and 44b of the substrate 40.

The plurality of inorganic light-emitting devices 50 may be mounted on the substrate 40 through a solder, instead of the anisotropic conductive layer 47. By performing a reflow process after arranging the inorganic light-emitting devices 50 on the substrate 40, the inorganic light-emitting devices 50 may be bonded on the substrate 40.

The anisotropic conductive layer 47 may be formed with a dark color. For example, the anisotropic conductive layer 47 may absorb external light such that the substrate 40 is shown to be black, thereby improving contrast of a screen. The anisotropic conductive layer 47 provided with a dark color may function to complement a light absorbing layer 44c formed on the entire mounting surface 41 of the substrate 40.

The display apparatus 1 may include the plurality of inorganic light-emitting devices 50. The plurality of inorganic light-emitting devices 50 may include a blue light-emitting device 50. For example, all of the plurality of inorganic light-emitting devices 50 may be blue inorganic light-emitting devices 50, although not limited thereto. However, the inorganic light-emitting devices 50 may be red light-emitting devices 50 and green light-emitting devices 50.

The inorganic light-emitting devices 50 may include a first inorganic light-emitting device 51, a second inorganic light-emitting device 52, and a third inorganic light-emitting device 53. The third inorganic light-emitting device 53 may be positioned between the first inorganic light-emitting device 51 and the second inorganic light-emitting device 52. However, the inorganic light-emitting devices 50 may be referred to as different names from those in the above example. For example, an inorganic light-emitting device positioned between the first inorganic light-emitting device 51 and the third inorganic light-emitting device 52 may be the second inorganic light-emitting device 53. Also, an inorganic light-emitting device positioned between the second inorganic light-emitting device 51 and the third inorganic light-emitting device 52 may be the first inorganic light-emitting device 53.

The first inorganic light-emitting device 51, the second inorganic light-emitting device 52, and the third inorganic light-emitting device 53 may be arranged at preset intervals in a line as in the embodiment of the disclosure, or may be arranged in another shape such as a triangle shape.

The display apparatus 1 may further include a color layer 100. The color layer 100 may convert a color of light emitted from the inorganic light-emitting devices 50. The color layer 100 may be positioned between the front cover 70 and the inorganic light-emitting devices 50. For example, the color layer 100 may be positioned between the front cover 70 and an adhesive layer 200 in the first direction X. The color layer 100 may be positioned in front of the inorganic light-emitting devices 50.

The color layer 100 may include optical layers 110, 120, and 130. The optical layers 110, 120, and 130 may diffuse light emitted from the inorganic light-emitting devices 50 toward the front direction X. For example, the optical layers 110, 120, and 130 may diffuse light emitted from the inorganic light-emitting devices 50 toward the front cover 70. The optical layers 110, 120, and 130 may also be referred to as light diffusion layers 110, 120, and 130.

The color layer 100 may include a resin 111 and 121 and a color conversion material 112 and 122. The resin 111 and 121 may be mixed with the color conversion material 112 and 122. The resin 111 and 121 may be transparent. The resin 111 and 121 or a mixture of the resin 111 and 121 and the color conversion material 112 and 122 may be provided inside the optical layers 110, 120, and 130.

Light emitted from the inorganic light-emitting devices 50 may be converted in color by passing through the color conversion material 112 and 122. For example, the color conversion material 112 and 122 may include quantum dots 112 and 122. However, a kind of the color conversion material 112 and 122 is not limited to this.

The optical layers 110, 120, and 130 may include a first optical layer 110, a second optical layer 120, and a third optical layer 130. The first optical layer 110 may correspond to the first inorganic light-emitting device 51, the second optical layer 120 may correspond to the second inorganic light-emitting device 52, and the third optical layer 130 may correspond to the third inorganic light-emitting device 53.

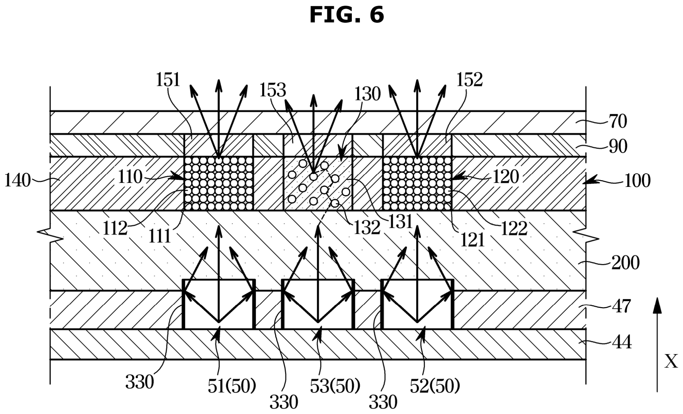

For example, light emitted from the first inorganic light-emitting device 51 may pass through the first optical layer 110. The light passed through the first optical layer 110 may be diffused and/or emitted in the front direction (see FIG. 6). For example, the light passed through the first optical layer 110 may show a Lambertian emission pattern. The first optical layer 110 may be a first color conversion layer 110. The light passed through the first color conversion layer 110 may show a first color. For example, the inorganic light-emitting device 50 may be a blue inorganic light-emitting device. In this case, the first color may be green. For example, the first color conversion layer 110 may be a green conversion layer.

The resin 111 and the quantum dots 112 may be positioned in the first color conversion layer 110. The quantum dots 112 may be positioned in the resin 111. The quantum dots 112 positioned in the first color conversion layer 110 may convert light passing through the first color conversion layer 110 into green light. Light passing through the first color conversion layer 110 may show a color by being absorbed in the quantum dots 112 and then emitted from the quantum dots 112, and the light may be emitted in all directions. Accordingly, light passed through the first color conversion layer 110 may show the Lambertian emission pattern and be emitted toward the front direction. The quantum dots 112 in the first color conversion layer 110 may be first quantum dots 112.

Also, for example, light emitted from the second inorganic light-emitting device 52 may pass through the second optical layer 120. The light passed through the second optical layer 120 may be diffused and/or emitted toward the front direction (see FIG. 6). For example, light passed through the second optical layer 120 may show the Lambertian emission pattern. The second optical layer 120 may be a second color conversion layer 120. Light passed through the second color conversion layer 120 may show a second color. For example, in a case in which the inorganic light-emitting device 50 is a blue inorganic light-emitting device 50, the second color may be red. For example, the second color conversion layer 120 may be a red conversion layer.

The resin 121 and the quantum dots 122 may also be positioned in the second color conversion layer 120. The quantum dots 122 may be positioned in the resin 121. The quantum dots 122 positioned in the second color conversion layer 120 may convert light passing through the second color conversion layer 120 into red light. Light passing through the second color conversion layer 120 may show a color by being absorbed in the quantum dots 122 and then emitted from the quantum dots 122, and the light may be emitted in all directions. Accordingly, light passed through the second color conversion layer 120 may show the Lambertian emission pattern and be emitted toward the front direction. The quantum dots 122 in the second color conversion layer 120 may be second quantum dots 122.

Also, for example, light emitted from the third inorganic light-emitting device 53 may pass through the third optical layer 130 (see FIG. 6). The third optical layer 130 may be a scattering layer 130. Light passed through the scattering layer 130 may be diffused and/or emitted toward the front direction. A resin may also be positioned inside the scattering layer 130. Details about the scattering layer 130 will be described later.

The color layer 100 and the inorganic light-emitting devices 50 may form a pixel. For example, the plurality of inorganic light-emitting devices 50, the first color conversion layer 110, the second color conversion layer 120, and the scattering layer 130 may form a pixel. In this case, each pair of the first inorganic light-emitting device 51 and the first color conversion layer 110, the second inorganic light-emitting device 52 and the second color conversion layer 120, and the third inorganic light-emitting device 53 and the scattering layer 130 may form a sub pixel. For example, the first inorganic light-emitting device 51 and the first color conversion layer 110 may form a green sub pixel, the second inorganic light-emitting device 52 and the second color conversion layer 120 may form a red sub pixel, and the third inorganic light-emitting device 53 and the scattering layer 130 may form a blue sub pixel.

The color layer 100 may further include a position guide 140. The position guide 140 may guide positions of the first color conversion layer 110, the second color conversion layer 120, and the scattering layer 130. The first color conversion layer 110, the second color conversion layer 120, and the scattering layer 130 may be located at correct positions by the position guide 140. The position guide 140 may guide positions of the resin 111, 121, and 131 (see FIG. 6), the quantum dots 112 and 122, and scattering particles 132 (see FIG. 6). The position guide 140 may be formed of an organic material and include a dark color. For example, the position guide 140 may have a gray color. The position guide 140 may be formed of a material having low transmittance. For example, the position guide 140 may be formed of a material having a high light absorption rate or high reflectance. Accordingly, the position guide 140 may absorb and/or reflect light traveling toward the position guide 140 among light diffused by the first color conversion layer 110, the second color conversion layer 120, and the scattering layer 130. The position guide 140 may also be referred to as a partition wall 140.

The position guide 140 may be positioned between the front cover 70 and the inorganic light-emitting devices 50. For example, the position guide 140 may be positioned between a black matrix 90 and the adhesive layer 200 in the first direction X.

The display apparatus 1 may further include the black matrix 90. For example, the color layer 100 may include the black matrix 90. The black matrix 90 may absorb external light and improve contrast. For example, the black matrix 90 may be positioned between the position guide 140 and the front cover 70 in the first direction X. A color filter 150 may be positioned between black matrixes 90.

The display apparatus 1 may further include the color filter 150. For example, the color filter 150 may be positioned between the front cover 70 and each of the optical layers 110, 120, and 130 along the first direction X. The color filter 150 may be positioned between the black matrixes 90 in the second direction Y or the third direction Z.

The color filter 150 may remove noise from light emitted from the optical layers 110, 120, and 130 in the front direction. For example, the inorganic light-emitting devices 50 may be blue inorganic light-emitting devices 50, and the color filter 150 may remove light not converted by the color conversion layers 110 and 120 among blue light.

For example, the color filter 150 may include a first color filter 151, a second color filter 152, and a third color filter 153. The first color filter 151 may remove noise from light emitted from the first color conversion layer 110 toward the front direction. For example, light passed through the first color conversion layer 110 may be green light having a first wavelength showing a green color, and the first color filter 151 may remove light having other wavelengths (or a different range) than the first wavelength showing the green color. The second color filter 152 may remove noise from light emitted from the second color conversion layer 120 toward the front direction. For example, light passed through the second color conversion layer 120 may be red light having a second wavelength showing a red color, and the second color filter 152 may remove light having other wavelengths (or a different range) than the second wavelength showing the red color. The third color filter 153 may remove noise from light emitted from the scattering layer 130 toward the front direction. For example, light emitted through the inorganic light-emitting devices 50 may be blue light having a third wavelength showing a blue color, and the third color filter 153 may remove light having other wavelengths (or a different range) than the third wavelength showing the blue color.

The substrate 40 may include the light absorbing layer 44c for absorbing external light and improving contrast. The light absorbing layer 44c may be formed on the entire mounting surface 41 of the substrate 40. The light absorbing layer 44c may be formed between the TFT layer 44 and the anisotropic conductive layer 47.

Each of the plurality of display modules 30A to 30P may include the front cover 70 positioned on the mounting surface 41 in the first direction X to cover the mounting surface 41, the inorganic light-emitting devices 50 and/or the color layer 100 of the plurality of display modules 30A to 30P.

A plurality of front covers 70 may be formed respectively on the plurality of display modules 30A to 30P in the first direction X.

After the front cover 70 is positioned on each of the plurality of display modules 30A to 30P, the plurality of display modules 30A to 30P may be assembled together. In examples of the first display module 30A and the second display module 30E of the plurality of display modules 30A to 30P, a first front cover may be formed on the mounting surface 41 of the first display module 30A, and a second front cover may be formed on the mounting surface 41 of the second display module 30E.

The front cover 70 may cover the substrate 40 and protect the substrate 40 from an external force or external water.

The front cover 70 may include a plurality of layers that may be a functional film having optical performance. For example, the front cover 70 may be a surface film.

Some of the plurality of layers of the front cover 70 may include a base layer formed of optical clear resin (OCR). The base layer may support a plurality of other layers. The OCR may be highly transparent with a transmittance greater than 90%.

The OCR may improve visibility and image quality by increasing transmittance due to low-reflection properties. For example, in a structure with an air gap, light loss occurs due to the difference in refractive index between a film layer and an air layer, whereas in a structure using OCR, the difference in refractive index may decrease, resulting in reduced light loss. As a result, visibility and image quality may be improved.

The OCR may not only protect the substrate 40, but also improve image quality.

The display apparatus 1 may include the adhesive layer 200 for adhering the front cover 70 to the mounting surface 41 of the substrate 40.

In general, the front cover 70 may have a height greater than a predetermined height in the first direction X toward which the mounting surface 41 or the light-emitting surface 54 faces.

Accordingly, in forming the front cover 70 on the substrate 40, a gap that may be formed between the front cover 70 and the plurality of inorganic light-emitting devices 50 may be sufficiently filled.

Also, each of the plurality of display modules 30A to 30P may include the rear adhesive tape 61 positioned between the rear surface 43 of the substrate 40 and the metal plate 60 to adhere the rear surface 43 to the metal plate 60.

The rear adhesive tape 61 may be a double-sided adhesive tape, although not limited thereto. However, the rear adhesive tape 61 may be an adhesive layer, not a tape. For example, the rear adhesive tape 61 is not limited to a tape as an example of a medium for adhering the rear surface 43 of the substrate 40 to the metal plate 60, and may be one of various kinds of mediums.

The plurality of inorganic light-emitting devices 50 may be electrically connected to a pixel driving wiring formed on the mounting surface 41, and an upper wiring layer extending through the side surface 45 of the substrate 40 and formed as a pixel driving wiring.

The upper wiring layer may be formed below the anisotropic conductive layer 47. The upper wiring layer may be electrically connected to the side wiring 46 formed on the side surface 45 of the substrate 40. The side wiring 46 may be in a form of a thin film (see FIG. 4).

A reflective layer 330 may be prepared, positioned, and formed on the side surface 55 of each of the plurality of inorganic light-emitting devices 50. The reflective layer 330 may be formed on both side surfaces 55 of the inorganic light-emitting device 50. The reflective layer 330 may improve the properties of light emitted from the inorganic light-emitting device 50. For example, light emitted from the inorganic light-emitting device 50 may be reflected from the both side surfaces 55 by the reflective layer 330, thereby providing a display apparatus in which a viewing angle and/or a beam angle is concentrated in a specific direction. Accordingly, a light-gathering efficiency of the display apparatus may be improved. The reflective layer 330 may be a reflective film. A method of manufacturing the reflective layer 330 will be described later.

FIG. 6 is an enlarged cross-sectional view showing some components of a display module in a display apparatus according to some embodiments of the disclosure. FIG. 6 is an enlarged view schematically illustrating some components shown in FIG. 5.

Referring to FIG. 6, in the display apparatus 1 according to some embodiments, each of the display modules 30A to 30P may include the inorganic light-emitting devices 50 and the color layer 100. Light emitted from the inorganic light-emitting devices 50 may travel toward the color layer 100.

The color layer 100 may include the scattering layer 130. The resin 131 and the scattering particles 132 may be provided inside the scattering layer 130. The resin 131 may be mixed with the scattering particles 132 inside the scattering layer 130. The scattering particles 132 may scatter light emitted from the inorganic light-emitting devices 50 toward the front direction. For example, light emitted from the third inorganic light-emitting device 50 may collide with the scattering particles 132 to form a great emission angle toward the front direction. However, the scattering particles 132 may be omitted.

For example, light emitted from the inorganic light-emitting devices 50 may be absorbed in and/or reflected from the position guide 140, or for another reason, a light emission pattern may be reduced, resulting in a reduction of a viewing angle. However, light passing through the first color conversion layer 110 and the second color conversion layer 120 may be absorbed in the quantum dots 112 and 122 and then emitted in all directions. Accordingly, the light passed through the first color conversion layer 110 and the second color conversion layer 120 may show the Lambertian emission pattern to have a wide viewing angle. For example, a viewing angle of light emitted from the first inorganic light-emitting device 51 and the second inorganic light-emitting device 52 may increase.

Also, light passing through the scattering layer 130 may collide with the scattering particles 132 to improve an emission pattern of the light. For example, part of light emitted from the third inorganic light-emitting device 53 may pass through the scattering layer 130 and another part of the light may be absorbed in and/or reflected from the position guide 140. Like the quantum dots 112 and 122 improving an emission pattern of light, the scattering particles 132 may scatter incident light. For example, the scattering particles 132 may collide with light entered the scattering layer 130 to cause the light to have a wide viewing angle toward the front direction. For example, a viewing angle of light emitted from the third inorganic light-emitting device 53 may increase. Accordingly, a user may watch the display apparatus 1 with reduced color coordination distortion depending on a viewing angle with respect to the display apparatus 1.

The scattering particles 132 may include TiO2, ZnO, ZrO2, and Al2O3. For example, a plurality of scattering particles 132 may be provided, and the respective scattering particles 132 may be formed of TiO2, ZnO, ZrO2, and Al2O3. Also, the plurality of scattering particles 132 may include at least one of TiO2, ZnO, ZrO2, or Al2O3, and also, N scattering particles 132 may be divided into N/4 each formed of TiO2, ZnO, ZrO2, or Al2O3. However, a composition of the scattering particles 132 is not limited to the above examples.

Also, each of the scattering particles 132 may have a size of 100 nm to 500 nm. However, the size of each scattering particle 132 is not limited to the above example.

Also, content of the scattering particles 132 may range from 2 wt% to 10 wt%. For example, the scattering particles 132 may be mixed with a resin, wherein the weight of scattering particles divided by the sum of the weight of scattering particles and weight of resin is equal to 2 wt% to 10 wt% ((weight of scattering particles) / (weight of scattering particles + weight of resin) = 2 wt% to 10 wt%). However, the content of the scattering particles 132 is not limited to the above example.

In a state in which the position guide 140 is positioned above the front cover 70, the color layer 100 including the scattering layer 130 may be manufactured. For example, the scattering layer 130 may be formed by applying a scattering particles solution obtained by mixing the resin 131 with the scattering particles 132 and then hardening the scattering particles solution. Then, the color layer 100 including the scattering layer 130 may rotate by 180 degrees and be adhered, coupled and/or attached to the inorganic light-emitting devices 50 and the anisotropic conductive layer 47 through the adhesive layer 200.

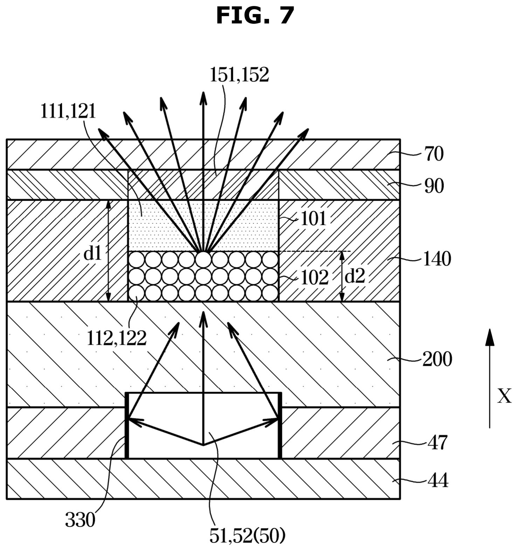

FIG. 7 is an enlarged cross-sectional view showing some components of a display module in a display apparatus according to 2 wt% to 10 wt%. of the disclosure. FIG. 7 is an enlarged view schematically illustrating some components shown in FIG. 5.

Referring to FIG. 7, the first color conversion layer 110 and/or the second color conversion layer 120 in the display apparatus 1 according to 2 wt% to 10 wt%. are shown. Or, at least one of the first color conversion layer 110 or the second color conversion layer 120 is shown.

The color filter 150 may include a resin layer 101 including the resin 111 and 121 that is transparent, and a quantum dot layer 102 in which the quantum dots 112 and 122 are mixed with the resin 111 and 121.

Light emitted from the inorganic light-emitting devices 50 toward the front direction may show the Lambertian emission pattern by the quantum dots 112 and 122 by passing through the quantum dot layer 102. For example, light emitted from the first inorganic light-emitting device 51 and/or the second inorganic light-emitting device 52 may be absorbed in the quantum dots 112 and 122 and then emitted in all directions.

According to 2 wt% to 10 wt%. , the quantum dot layer 102 may be formed in lower portions of the color conversion layers 110 and 120 and/or the color layer 100. A ratio of a thickness of the quantum dot layer 102 with respect to a thickness of the color conversion layers 110 and 120 and/or the color layer 100 may range from 0.2 to 1. Because the quantum dot layer 102 is positioned in the lower portions of the color conversion layers 110 and 120, part of light again emitted from the quantum dot layer 102 may be absorbed in the position guide 140, and another part of light not absorbed in the position guide 140 may be emitted in the front direction. Accordingly, an emission angle of light emitted from the color conversion layers 110 and 120 may be reduced.

Light emitted from a red sub pixel and a green sub pixel may be less reduced in brightness than light scattered in a blue sub pixel, which causes a brightness difference to generate color coordinate distortion depending on a viewing angle.

According to some embodiments, because an emission angle of light emitted from the color conversion layers 110 and 120 may be reduced, brightness differences between the sub pixels may be reduced and color coordinate distortion may be reduced.

After the front cover 70 is positioned below the color layer 100, a resin solution consisting of the resin 111 and 121 may be applied in spaces of the color conversion layers 110 and 120 of FIG. 7. Thereafter, a process of immediately hardening the resin solution may be performed. After the resin solution is hardened, a quantum dot solution in which the resin 111 and 121 is mixed with the quantum dots 112 and 122 may be additionally applied. The quantum dot solution may be applied in the color conversion layers 110 and 120 to have a smaller thickness than that of the color conversion layers 110 and 120 that are finally formed. Thereafter, a process of immediately hardening the quantum dot solution may be performed.

Then, the color layer 100 including the color conversion layers 110 and 120 may rotate by 180 degrees and be adhered, coupled and/or attached to the inorganic light-emitting devices 50 and the anisotropic conductive layer 47 through the adhesive layer 200.

The quantum dots 112 and 122 may be biased to one side within the color conversion layers 110 and 120. For example, the quantum dots 112 and 122 may be positioned adjacent to the adhesive layer 200 and/or the inorganic light-emitting devices 50. For example, the quantum dots 112 and 122 may be positioned at rear portions of the color conversion layers 110 and 120. A ratio d2/d1 of a thickness d2 of the quantum dot layer 102 in which the quantum dots 112 and 122 are positioned with respect to a thickness d1 of the color conversion layers 110 and 120 may range from 0.2 to 1.

In the color conversion layers 120 and 120, different kinds of structures of the quantum dot layer 102 in which the resin 111 and 121 is mixed with the quantum dots 112 and 122 and the resin layer in which only the resin 111 and 121 is positioned may be formed. The quantum dot layers 102 may be positioned at the lower portions of the color conversion layers 110 and 120.

As described above, part of light emitted from the quantum dot layer 102 positioned at the lower portions of the color conversion layers 110 and 120 may be absorbed in the position guide 140, and another part of light not absorbed in the position guide 140 may be emitted in the front direction. Accordingly, an emission angle of light emitted from the color conversion layers 110 and 120 may be reduced. The display apparatus 1 according to some embodiments may reduce a difference between an emission angle of light emitted from the red and/or green sub pixel and an emission angle of light emitted from the blue sub pixel, thereby reducing color coordinate distortion depending on a viewing angle.

Meanwhile, by configuring red/green color filter layers with different kinds of structures of a transparent resin layer (upper portion) and a quantum dot layer (lower portion), a traveling path of converted light emitted from the quantum dot layer of the lower portion may be limited. In this way, by changing the structure of the color filter, an emission angle of red/green emitted from the display apparatus 1 may be reduced.

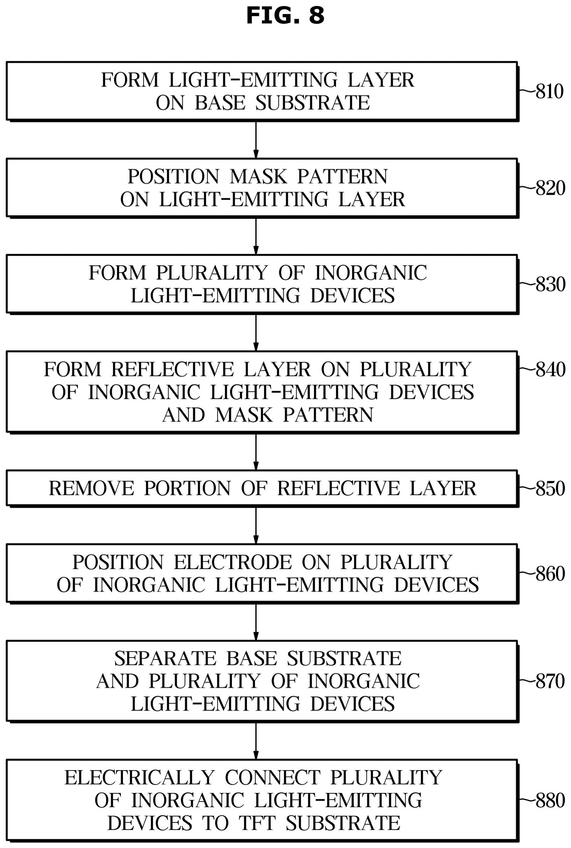

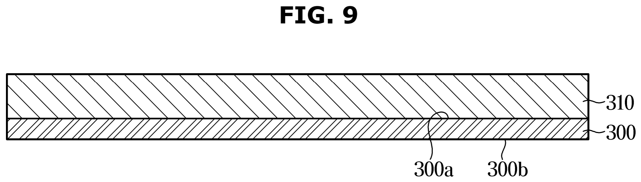

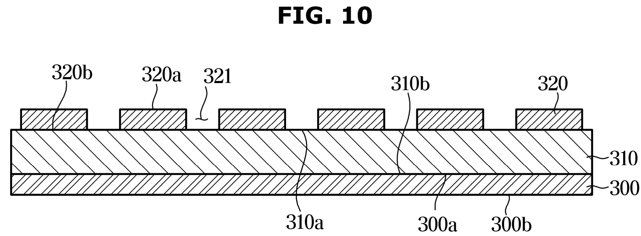

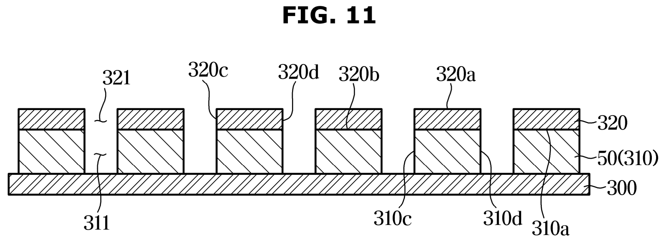

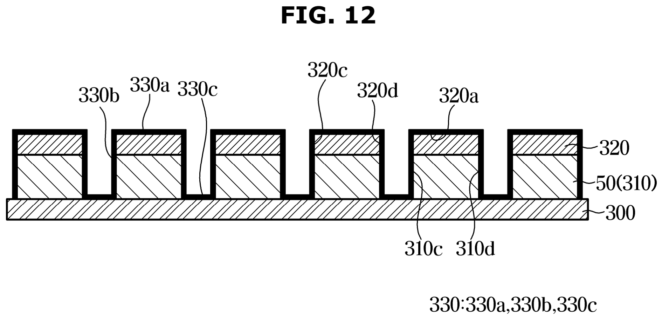

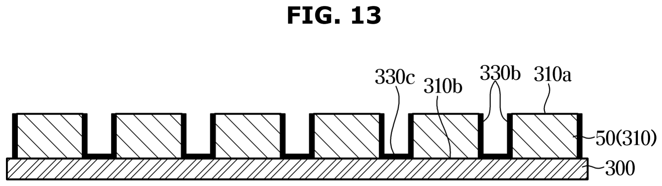

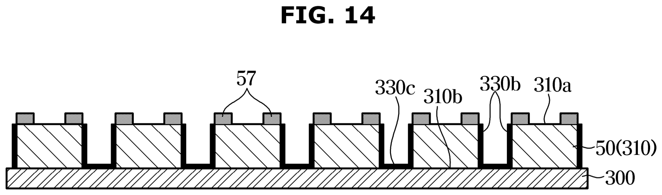

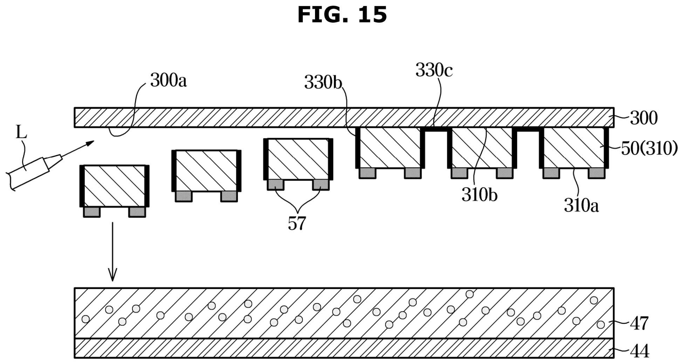

FIG. 8 is a flowchart illustrating a process of manufacturing a display module in a display apparatus according to some embodiments of the disclosure. FIG. 9 is a schematic view illustrating a process of manufacturing a color layer of a display module in a display apparatus according to some embodiments of the disclosure. FIG. 10 is a schematic view illustrating a process of manufacturing a display module in a display apparatus according to some embodiments of the disclosure. FIG. 11 is a schematic view illustrating a process of manufacturing a display module in a display apparatus according to some embodiments of the disclosure. FIG. 12 is a schematic view illustrating a process of manufacturing a display module in a display apparatus according to some embodiments of the disclosure. FIG. 13 is a schematic view illustrating a process of manufacturing a display module in a display apparatus according to some embodiments of the disclosure. FIG. 14 is a schematic view illustrating a process of manufacturing a display module in a display apparatus according to some embodiments of the disclosure. FIG. 15 is a schematic view illustrating a process of manufacturing a display module in a display apparatus according to some embodiments of the disclosure.

Referring to FIG. 8 and FIG. 9, in the display apparatus according to some embodiments, a method of manufacturing a display module may include forming the light-emitting layer 310 on the base substrate 300 (810).

The base substrate 300 may include a first surface 300a and a second surface 300b that is opposite to the first surface 300a. For example, the base substrate 300 may be positioned such that the first surface 300a faces upward and the second surface 300b is supported by a flat floor, etc. For example, the base substrate 300 may be a sapphire substrate and/or a glass substrate.

The light-emitting layer 310 may be formed on the first surface 300a of the base substrate 300. For example, the light-emitting layer 310 may be placed on the base substrate 300. For example, the second surface 300b of the light-emitting layer 310 may be applied directly onto the first surface 300a of the base substrate 300.

The light-emitting layer 310 may include a first surface 310a and a second surface 310b that is opposite to the first surface 310a. For example, the first surface 310a of the light-emitting layer 310 may face upward, and the second surface 310b may be in contact with the first surface 300a of the base substrate 300.

The light-emitting layer 310 may include a plurality of semiconductor layers. For example, the light-emitting layer 310 may include a p-type semiconductor, an n-type semiconductor, a dielectric layer, a sub-light-emitting layer, and the like. For example, the sub-light-emitting layer may be a blue light-emitting layer. However, the disclosure is not limited thereto, and the sub-light-emitting layer may be a green light-emitting layer or a red light-emitting layer.

In addition, the light-emitting layer 310 may include gallium nitride (GaN). For example, at least a portion of the light-emitting layer 310 may be formed of gallium nitride (GaN).

Referring to FIG. 8 and FIG. 10, in the display apparatus according to some embodiments, the method of manufacturing a display module may include positioning a mask pattern 320 on the light-emitting layer 310 (820). The mask pattern 320 may include a cover that covers the light-emitting layer 310 .

The mask pattern 320 may be formed on the first surface 310a of the light-emitting layer 310. For example, the mask pattern 320 may be positioned on the first surface 310a of the light-emitting layer 310.

The mask pattern 320 may include a first surface 320a and a second surface 320b that is opposite to the first surface 320a. For example, the first surface 320a of the mask pattern 320 may face upward, and the second surface 320b may face the first surface 310a of the mask pattern 310.

The mask pattern 320 may include a photoresist. For example, the photoresist may be positioned on the first surface 310a of the light-emitting layer 310.

The mask pattern 320 may include a PR mask. For example, the photoresist may be applied to the first surface 310a of the light-emitting layer 310, and the PR mask may be positioned on the photoresist.

In addition, the mask pattern 320 may include a Fine Metal Mask (FMM). For example, the photoresist may be applied to the first surface 310a of the light-emitting layer 310, and the FMM may be positioned on the photoresist. For example, the FMM may include aluminum.

An aperture 321 may be formed in the mask pattern 320. For example, in a case where the mask pattern includes a photoresist, the aperture 321 may be formed in the photoresist by etching. In addition, for example, in a case where the mask pattern includes a PR mask, the aperture 321 may be formed in the PR mask, and a portion of the light-emitting layer 310 positioned below the aperture 321 may be removed by etching. In addition, for example, in a case where the mask pattern includes an FMM, the aperture 321 may be formed in the FMM, and a portion of the light-emitting layer 310 positioned in the aperture 321 may be removed by etching. The aperture 321 may be a hole, a pattern, and the like.

Referring to FIG. 8 and FIG. 11, in the display apparatus according to some embodiments, the method of manufacturing a display module may include forming a plurality of inorganic light-emitting devices 50 (830). For example, the light-emitting layer 310 positioned below the aperture 321 may be exposed through the aperture 321, and then etched and removed, thereby dividing and/or forming the light-emitting layer 310 into the plurality of inorganic light-emitting devices 50 (Positive PR). In addition, for example, the light-emitting layer 310 not positioned below the aperture 321 may be exposed through the aperture 321, and then etched and removed, thereby dividing and/or forming the light-emitting layer 310 into the plurality of inorganic light-emitting devices 50 (Negative PR). The plurality of inorganic light-emitting devices 50 may have a plurality of light-emitting structures and/or a plurality of light-emitting layers. For example, in a case where the mask pattern 320 includes a photoresist and a PR mask, the PR mask may be removed after dividing and/or forming the light-emitting layer 310 into the plurality of inorganic light-emitting devices 50.

By etching the light-emitting layer 310, the plurality of inorganic light-emitting devices 50 may be formed, and each of the plurality of inorganic light-emitting devices 50 may include both side surfaces 310c and 310d. The side surface 55 (see FIG. 5) of each of the plurality of inorganic light-emitting devices 50 may include both side surfaces 310c and 310d of the plurality of inorganic light-emitting devices 310. The both side surfaces 310c and 310d may include the third side surface 310c and the fourth side surface310d. The third surface 310c and the fourth surface 310d may be positioned on opposite sides and connect the first surface 310a and the second surface 310b. A hole 311 that partitions the plurality of inorganic light-emitting devices 50 may be formed between the third surface 310c and the fourth surface 310d by etching through the aperture 321. In addition, the bottom surface 56 of the plurality of inorganic light-emitting devices 50 may include the first surface 310a of the plurality of inorganic light-emitting devices 310.

The mask pattern 320 may also include a third surface 320c and a fourth surface 320d forming the aperture 321. For example, the aperture 321 may be formed between the third surface 320c and the fourth surface 320d of the mask pattern 320. The third surface 320c and the fourth surface 320d may be positioned on opposite sides and connect the first surface 320a and the second surface 320b.

Referring to FIG. 8 and FIG. 12, in the display apparatus according to some embodiments, the method of manufacturing a display module may include forming the reflective layer 330 on the plurality of inorganic light-emitting devices 50 and the mask pattern 320 (840). For example, the reflective layer 330 may be deposited on side surfaces of the plurality of inorganic light-emitting devices 50 and surfaces of the mask pattern 320. For example, the reflective layer 330 may be formed on the third surface 310c and the fourth surface 310d of the plurality of inorganic light-emitting devices 50, and on the first surface 320a, the third surface 320c, and the fourth surface 320d of the mask pattern 320. In addition, the reflective layer 330 may also be formed on the first surface 310a of the base substrate 300.

For example, in a case where the mask pattern 320 includes a photoresist, the reflective layer 330 may be formed on the photoresist without removing the photoresist.

In addition, for example, in a case where the mask pattern 320 includes an FMM, the reflective layer 330 may be formed on the FMM after removing the photoresist.

The reflective layer 330 may include a plurality of portions. For example, the reflective layer 330 may include a first portion330a, a second portion330b, and a third portion330c. The first portion 330a may be formed on the first surface 320a of the mask pattern 320. The second portion 330b may be formed on the third surface 320c and the fourth surface 320d of the mask pattern 320 and the third and fourth surfaces of the inorganic light-emitting device 50. The third portion 330c may be formed on the first surface 310a of the base substrate 300.

The reflective layer 330 may include an inorganic material. For example, the reflective layer 330 may include TiO2, TiN, AlN, Al2O3, SnO2, WO3, and ZrO2.

Referring to FIG. 8 and FIG. 13, in the display apparatus according to some embodiments, the method of manufacturing a display module may include removing a portion of the reflective layer 330 (850). For example, a portion of the reflective layer 330 on the mask pattern 320 side may be removed. For example, the reflective layer 330 formed on the first surface 320a, the third surface 320c, and the fourth surface 320d of the mask pattern 320 may be removed. A portion of the reflective layer 330 may be removed by removing the mask pattern 320. A method of removing a portion of the reflective layer 330 and the mask pattern 320 will be described later.

By removing the mask pattern 320, the first portion 330a and a portion of the second portion 330b of the reflective layer 330 may be removed, and only the other portion of the second portion 330b and the third portion 330c may remain. For example, among the reflective layer 330, a portion of the second portion 330b on the third surface 310c and the fourth surface 310d of the plurality of inorganic light-emitting devices 50 and the third portion 330c on the first surface 300a of the base substrate 300 may remain.

Referring to FIG. 8 and FIG. 14, in the display apparatus according to some embodiments, the method of manufacturing a display module may include positioning the electrode 57 on the plurality of inorganic light-emitting devices 50 (860). For example, according to the method of manufacturing a display module, the mask pattern 320 positioned on the first surface 310a of the plurality of inorganic light-emitting devices 50 may be removed and the electrode 57 may be positioned on one surface of each of the plurality of inorganic light-emitting devices 50. For example, the electrode 57 may be positioned on the first surface 310a of the plurality of inorganic light-emitting devices 50. The electrode 57 may be electrically connected to the inorganic light-emitting device 50, and allow the inorganic light-emitting device 50 to be electrically connected to the TFT substrate 44. For example, the electrode 57 may include the first contact electrode 57a and/or the second contact electrode 57b (see FIG. 5).

Referring to FIG. 8 and FIG. 15, in the display apparatus according to some embodiments, the method of manufacturing a display module may further include separating the base substrate 300 and the plurality of inorganic light-emitting devices 50 (870). For example, according to the method of manufacturing a display apparatus according to an embodiment, the base substrate 300 and the plurality of inorganic light-emitting devices 50 may be separated by radiating a laser between the base substrate 300 and the plurality of inorganic light-emitting devices 50 using Laser Lift Off (LLO). For example, the plurality of inorganic light-emitting devices 50 may be separated from the first surface 300a of the base substrate 300 using a laser device L. For example, the laser may be a short wavelength laser of 200 to 350 nm.

While the base substrate 300 and the plurality of inorganic light-emitting devices 50 are separated, the third portion 330c of the reflective layer 330 may be removed. For example, based on the plurality of inorganic light-emitting devices 50 being separated from the base substrate 300, the third portion 330c of the reflective layer 330 may be torn or fallen apart. Accordingly, only the second portion 330b of the reflective layer 330 may remain.

The plurality of inorganic light-emitting devices 50 and the base substrate 300 may be separated on the TFT substrate 44. Based on the plurality of inorganic light-emitting devices 50 being separated from the base substrate 300, the plurality of inorganic light-emitting devices 50 may be moved to the TFT substrate 44 on which the anisotropic conductive layer 47 is applied.

The plurality of inorganic light-emitting devices 50 may be moved directly from the base substrate 300 to the TFT substrate 44. The plurality of inorganic light-emitting devices 50 may also be moved from a mediate substrate to the TFT substrate 44, after the plurality of inorganic light-emitting devices 50 are moved from the base substrate 300 to the mediate substrate. For example, based on the plurality of inorganic light-emitting devices 50 being moved from the base substrate 300 to the mediate substrate, the electrode 57 may be positioned on the second surface 310b of the plurality of inorganic light-emitting devices 50. In addition, the plurality of inorganic light-emitting devices 50 may be moved to the mediate substrate more than twice.

The method of manufacturing a display module 30 may further include electrically connecting the plurality of inorganic light-emitting devices 50 to the TFT substrate 44 (880). After the plurality of inorganic light-emitting devices 50 are moved to the TFT substrate 44 on which the anisotropic conductive layer 47 is applied, the inorganic light-emitting devices 50 may be electrically connected through electrical connection between the contact electrodes 57a and 57b and the pad electrodes 44a and 44b (see Figure 5).

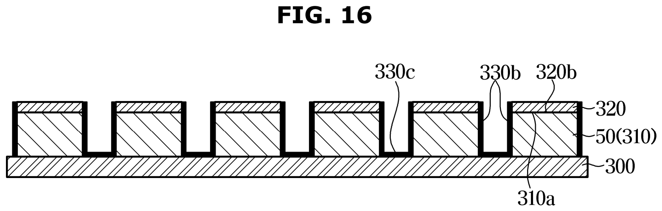

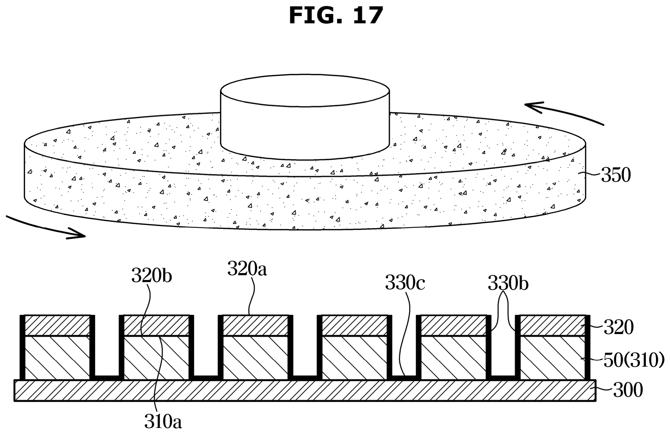

FIG. 16 is a schematic view illustrating a process of manufacturing a display module in a display apparatus according to some embodimentsof the disclosure. FIG. 16 illustrates that a portion of a mask pattern is removed by etching. FIG. 17 is a schematic view illustrating a process of manufacturing a display module in a display apparatus according to some embodimentsof the disclosure. FIG. 17 illustrates that a portion of a mask pattern is removed by polishing and/or grinding.

Referring to FIG. 16, removing a portion of the reflective layer 330 (850) may include removing the photoresist 320 positioned on the first surface 310a of the plurality of inorganic light-emitting devices 50. For example, in a case where the mask pattern 320 includes the photoresist 320, removing the mask pattern 320 may include dry etching and/or wet etching the photoresist 320.

For example, in a case of dry etching the mask pattern 320, the photoresist 320 positioned on an upper surface of the inorganic light-emitting device 50 may be removed using plasma. The photoresist 320 may be removed using plasma until the first surface 310a of the inorganic light-emitting device 50 is exposed.

For example, in a case of wet etching the mask pattern 320, the photoresist 320 may be removed by melting the photoresist 320 with a chemical solvent until the first surface 310a of the inorganic light-emitting device 50 is exposed, or by spraying the chemical solvent on the photoresist 320.

Referring to FIG. 17, removing the photoresist 320 may include polishing and/or grinding the photoresist 320. For example, the photoresist 320 may be removed by dry polishing, or by wet polishing using a polishing device 350. Polishing may be performed until the first surface 310a of the inorganic light-emitting device 50 is exposed.

As a result, because the photoresist 320 is removed, only the second portion 330b and the third portion 330c of the reflective layer 330 may remain, and then the inorganic light-emitting device 50 may be separated from the base substrate 300, and thus only the third portion 330c may remain.

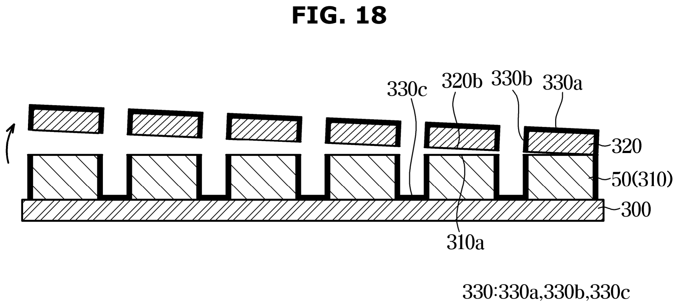

FIG. 18 is a schematic view illustrating a process of manufacturing a display module in a display apparatus according to some embodiments of the disclosure.

Referring to FIG. 18, removing a portion of the reflective layer 330 (850) may include removing the FMM 320 positioned on the first surface 310a of the plurality of inorganic light-emitting devices 50. For example, in a case where the mask pattern 320 includes the FMM 320, photoresist may be applied onto the light-emitting layer 310, and the applied photoresist may be exposed along the aperture 321. Then, the exposed photoresist may be etched and/or removed to form the plurality of inorganic light-emitting devices 50. Thereafter, the FMM 320 may be positioned on the first surface 310a of the inorganic light-emitting device 50. After the FMM 320 is positioned on the inorganic light-emitting device 50, the reflective layer 330 may be formed, and then the mask pattern 320 and the reflective layer 330 may be removed from the inorganic light-emitting device 50. In this instance, removing the mask pattern 320 may include separating the FMM 320 from the plurality of inorganic light-emitting devices 50.

Accordingly, the FMM 320 may be separated (fallen apart) from the inorganic light-emitting device 50 on one side of the display module. The first surface 310a of the inorganic light-emitting device 50 and the second surface 320b of the FMM 320 may be separated.

As a result, because the mask pattern 320 is removed, only the second portion 330b and the third portion 330c of the reflective layer 330 may remain, and then the inorganic light-emitting device 50 is separated from the base substrate 300, and thus only the third portion 330c may remain.

According to an aspect of the disclosure, by forming a reflective layer on both side surfaces of an inorganic light-emitting device, a display apparatus with improved optical properties may be provided.

The effects that may achieved by the disclosure are not limited to the above-mentioned effects, and other effects not mentioned will be clearly understood by one of ordinary skill in the technical art to which the disclosure belongs from the following description.

According to an embodiment of the disclosure, a method of manufacturing a display module of a plurality of display modules arranged in a display apparatus may include: forming a light-emitting layer on a base substrate (810); positioning a mask pattern having an aperture on the light-emitting layer (820); forming a plurality of inorganic light-emitting devices by etching the light-emitting layer through the aperture (830); forming a reflective layer on the mask pattern and the plurality of inorganic light-emitting devices (840); and removing the mask pattern, positioned on the plurality of inorganic light-emitting devices, and the reflective layer formed on the mask pattern (850).

Each of the plurality of inorganic light-emitting devices may include: a first surface 310a on which the mask pattern is positioned; a second surface 310b arranged on an opposite side of the first surface to contact the base substrate; a third surface 310c arranged between the first surface and the second surface to connect the first surface and the second surface; and a fourth surface 310d arranged on an opposite side of the third surface to connect the first surface and the second surface between the first surface and the second surface, wherein the forming of the reflective layer may include forming the reflective layer on the third surface and the fourth surface of each of the plurality of inorganic light-emitting devices.

The mask pattern may include: a first surface 310a; a second surface 310b arranged on an opposite side of the first surface of the mask pattern to contact a first surface of the reflective layer; a third surface 310c arranged between the first surface and the second surface of the mask pattern to connect the first surface and the second surface of the mask pattern; and a fourth surface 310d arranged on an opposite side of the third surface of the mask pattern to connect the first surface and the second surface of the mask pattern between the first surface and the second surface of the mask pattern, wherein the forming of the reflective layer may include forming the reflective layer on the first surface, the third surface, and the fourth surface of the mask pattern.

The method may further include separating the base substrate from the second surface of each of the plurality of inorganic light-emitting devices by radiating a laser (870).

The method may further include electrically connecting the plurality of inorganic light-emitting devices to a Thin Film Transistor (TFT) substrate (880).

The method may further include removing the mask pattern positioned on the first surface of each of the plurality of inorganic light-emitting devices, and positioning an electrode on the first surface of each of the plurality of inorganic light-emitting devices (860), wherein the plurality of inorganic light-emitting devices may be electrically connected to the TFT substrate through the electrode and after the electrode is positioned on the first surface.

The mask pattern may include a photoresist, and the removing of the mask pattern and the reflective layer formed on the mask pattern (850) may include: removing the mask pattern by at least one of grinding, polishing, or etching.

The removing of the mask pattern and the reflective layer formed on the mask pattern (850) may further include removing the mask pattern by at least one of dry etching or wet etching.

The removing of the mask pattern and the reflective layer formed on the mask pattern (850) may further include removing the mask pattern by dry etching using plasma.

The removing of the mask pattern and the reflective layer formed on the mask pattern (850) may include at least one of dry polishing or wet polishing.

The mask pattern may include a Fine Metal Mask (FMM), and the removing of the mask pattern and the reflective layer formed on the mask pattern (850) may include separating the FMM from the plurality of inorganic light-emitting devices.

The forming of the reflective layer (840) may include forming the reflective layer using a Plasma Enhanced Chemical Vapor Deposition (PECVD), and the reflective layer may include TiO2.

The mask pattern may include at least one of a photoresist or a FMM.

The display apparatus may include: a front cover 70 configured to cover the plurality of inorganic light-emitting devices; and a color layer 100 positioned between the front cover and the plurality of inorganic light-emitting devices, and wherein the color layer may include: color conversion layers 110 and 120 through which light emitted from the plurality of inorganic light-emitting devices passes; a scattering layer 130 through which light emitted from the plurality of inorganic light-emitting devices passes; and a scattering particle 132 arranged in the scattering layer to scatter the light passing through the scattering layer.

The color layer 100 may further include: a position guide 140 positioned among the first color conversion layer 110, the second color conversion layer 120, and the scattering layer 130, and each of the plurality of display modules 30 may further include: a black matrix 90 positioned between the front cover and the position guide; and a color filter 150 positioned between the color layer and the front cover.

According to some embodiments of the disclosure, in a display apparatus including a display module array in which a plurality of display modules 30 are arranged, each of the plurality of display modules 30 may include: a substrate 40; an inorganic light-emitting device 50 configured to be mounted on the substrate and including both side surfaces 55 (i.e. a first side surface and a second side surface); a color layer 100 in front of the inorganic light-emitting device and configured to allow light emitted from the inorganic light-emitting device to pass therethrough and including quantum dots 112 and 122 configured to allow light passing through the color layer to be color converted; and a reflective film 330 positioned on the first side surface and the second side surface of the inorganic light-emitting device to reflect the light emitted from the inorganic light-emitting device.

The inorganic light-emitting device may include a plurality of inorganic light-emitting devices, and the plurality of inorganic light-emitting devices may include a first inorganic light-emitting device 51, a second inorganic light-emitting device 52, and a third inorganic light-emitting device 53. The color layer may include: a first color conversion layer 110 through which light emitted from the first inorganic light-emitting device 51 passes and in which the quantum dot 112 (first quantum dot) is positioned; a second color conversion layer 120 through which light emitted from the second inorganic light-emitting device 52 passes and in which the quantum dot 122 (second quantum dot) is positioned; a scattering layer 130 through which light emitted from the third inorganic light-emitting device 53 passes; and a scattering particle 132 arranged in the scattering layer and configured to scatter the light emitted from the third inorganic light-emitting device 53 that has passed through the scattering layer.

The color layer 100 may further include: a position guide positioned among the first color conversion layer 110, the second color conversion layer 120, and the scattering layer 130.

Each of the plurality of display modules 30 may further include: a black matrix 90 positioned between the front cover and the position guide; and a color filter 150 positioned between the color layer and the front cover.

According to some embodiments of the disclosure, a method of manufacturing a display module of a plurality of display modules arranged in a display apparatus may include: forming a light-emitting layer on a base substrate (810); positioning a photoresist having an aperture on the light-emitting layer (820); forming a plurality of inorganic light-emitting structures by etching the light-emitting layer through the aperture of the photoresist (830); forming a reflective layer 330 on a surface of the photoresist that forms the aperture and a surface of each of the plurality of inorganic light-emitting structures (840); and removing the reflective layer formed on the photoresist by dry etching the photoresist positioned on an upper surface of each of the plurality of inorganic light-emitting structures (850).

While certain example embodiments the disclosure have been particularly shown and described, it will be understood that various changes in form and details may be made therein without departing from the spirit and scope of the following claims.

## Claims

1. A method of manufacturing a display module of a plurality of display modules arranged in 1. A method of manufacturing a display module of a plurality of display modules arranged in a display apparatus, the method comprising:
forming a light-emitting layer on a base substrate;
positioning a mask pattern having an aperture on the light-emitting layer;
forming a plurality of inorganic light-emitting devices by etching the light-emitting layer through the aperture;
forming a reflective layer on the mask pattern and the plurality of inorganic light-emitting devices; and
removing the mask pattern positioned on the plurality of inorganic light-emitting devices and removing the reflective layer formed on the mask pattern.

2. The method of claim 1, wherein each of the plurality of inorganic light-emitting devices comprises:
a first surface on which the mask pattern is positioned;
a second surface on an opposite side of the first surface and contacting the base substrate;
a third surface between the first surface and the second surface and connecting the first surface and the second surface; and
a fourth surface on an opposite side of the third surface between the first surface and the second surface and connecting the first surface and the second surface,
wherein the forming of the reflective layer comprises forming the reflective layer on the third surface and the fourth surface of each of the plurality of inorganic light-emitting devices.

3. The method of claim 2, wherein the mask pattern comprises:
a first surface;
a second surface arranged on an opposite side of the first surface of the mask pattern and contacting a first surface of the reflective layer;
a third surface arranged between the first surface of the mask pattern and the second surface of the mask pattern and contacting the first surface of the mask pattern and the second surface of the mask pattern; and
a fourth surface arranged on an opposite side of the third surface of the mask pattern between the first surface of the mask pattern and the second surface of the mask pattern and contacting the first surface and the second surface of the mask pattern,
wherein the forming of the reflective layer comprises forming the reflective layer on the first surface of the mask pattern, the third surface of the mask pattern, and the fourth surface of the mask pattern.

4. The method of claim 3, further comprising: separating the base substrate from the second surface of each of the plurality of inorganic light-emitting devices by radiating a laser.

5. The method of claim 4, further comprising electrically connecting the plurality of inorganic light-emitting devices to a Thin Film Transistor (TFT) substrate.

6. The method of claim 5, further comprising removing the mask pattern positioned on the first surface of each of the plurality of inorganic light-emitting devices, and positioning an electrode on the first surface of each of the plurality of inorganic light-emitting devices,
wherein the electrically connecting the plurality of inorganic light-emitting devices to a TFT substrate is through the electrode positioned on the first surface of each of the plurality of inorganic light-emitting devices and after the electrode is positioned on the first surface of each of the plurality of inorganic light-emitting devices.

7. The method of claim 3, wherein the mask pattern comprises a photoresist, and
wherein the removing the mask pattern positioned on the plurality of inorganic light-emitting devices and removing the reflective layer formed on the mask pattern comprises removing the mask pattern by at least one of grinding, polishing, or etching.

8. The method of claim 7, wherein the removing the mask pattern positioned on the plurality of inorganic light-emitting devices and removing the reflective layer formed on the mask pattern further comprises removing the mask pattern by at least one of dry etching or wet etching.

9. The method of claim 8, wherein the removing the mask pattern positioned on the plurality of inorganic light-emitting devices and removing the reflective layer formed on the mask pattern further comprises removing the mask pattern by dry etching using plasma.

10. The method of claim 7, wherein the removing the mask pattern positioned on the plurality of inorganic light-emitting devices and removing the reflective layer formed on the mask pattern comprises at least one of dry polishing or wet polishing.

11. The method of claim 2, wherein the mask pattern comprises a Fine Metal Mask (FMM), and
wherein the removing the mask pattern positioned on the plurality of inorganic light-emitting devices and removing the reflective layer formed on the mask pattern comprises separating the FMM from the plurality of inorganic light-emitting devices.

12. The method of claim 1, wherein the forming the reflective layer on the mask pattern and the plurality of inorganic light-emitting devices comprises forming the reflective layer using a Plasma Enhanced Chemical Vapor Deposition (PECVD), and
wherein the reflective layer comprises TiO2.

13. The method of claim 12, wherein the mask pattern comprises at least one of a photoresist or a FMM.

14. The method of claim 2, wherein the display apparatus comprises:
a front cover configured to cover the plurality of inorganic light-emitting devices; and
a color layer between the front cover and the plurality of inorganic light-emitting devices,
wherein the color layer comprises:
a color conversion layer through which light emitted from the plurality of inorganic light-emitting devices passes;
a scattering layer through which light emitted from the plurality of inorganic light-emitting devices passes; and
a scattering particle arranged in the scattering layer and configured to scatter the light which passes through the scattering layer.

15. The method of claim 14, wherein the color layer further comprises a position guide positioned among a first color conversion layer, a second color conversion layer, and the scattering layer, and
wherein each of the plurality of display modules further comprises:
a black matrix between the front cover and the position guide; and
a color filter between the color layer and the front cover.
